Europäisches Patentamt

European Patent Office

Office européen des brevets

(19)

(11) Publication number: **0 431 416 A2**

(12)

# EUROPEAN PATENT APPLICATION

(21) Application number: **90122381.8**

(51) Int. Cl.5: **H03M 13/00**

(22) Date of filing: **23.11.90**

(30) Priority: **04.12.89 US 445964**

(43) Date of publication of application:
**12.06.91 Bulletin 91/24**

(84) Designated Contracting States:
**DE FR GB IT**

(71) Applicant: **NATIONAL SEMICONDUCTOR
CORPORATION
2990 Semiconductor Drive**
Santa Clara, CA. 95051-8090(US)

(72) Inventor: **Perloff, Ronald S.
14065 Willow Ranch Road
Poway, CA 92064(CA)**

(74) Representative: **Sparing Röhl Henseler
Patentanwälte European Patent Attorneys
Rethelstrasse 123
W-4000 Düsseldorf 1(DE)**

(54) **Apparatus and method for accessing a cyclic redundancy error check code generated in parallel.**

(57) An error check code generating system (300, 400) includes means for generating a plurality of remainder coefficients (200, 100) forming an error check code for a valid data sequence received by the system (300, 400) and according to a generator polynomial G(x). The system (300, 400) includes a plurality of remainder storage elements (40, 42, 44, 46) which each store in parallel certain of the remainder coefficients comprising the error check code. The system (300, 400) employs a control signal (24) having a logic state associated therewith and a plurality of logical AND-gates (26, 260). The control signal (24) is one input to the logical AND-gates (26, 260) which output a register control signal (28, 340, 360, 380). The register control signal (28, 340, 360, 380) is a logic zero when the control signal (24) is a logic zero. The register control signal (28, 340, 360, 380) is input to the means for generating the remainder coefficients (200, 100) such that when the register control signal (28, 340, 360, 380) is a logic zero, the logic state of the remainder coefficients is preserved. The system (300, 400) includes a selectable multiplexor (52) which either outputs the data sequence or a plurality of the remainder coefficients (39).

F I G. 3

The present invention broadly relates to a cyclic redundancy error check code generator and more particularly, the invention relates to a cyclic error check code generator which processes byte-wide data in parallel and provides means for accessing the cyclic error check code generated.

In communication systems, data is typically transferred between processing units and peripheral units, storage devices, or user terminals. Errors may be introduced during the reading, writing, or actual transmission process. Error control has become an integral part of the design of computers and communication systems. One method employed for error detection involves the addition of one or more bits, called redundancy bits, at the end of the block of information-carrying bits. The redundancy bits do not carry any data information; they are merely used to determine the correctness of the bit stream carrying the information.

Cyclic redundancy checking is an algorithmic error-detecting technique used to verify that the digital information received is correct. A digital data word (*d*) is written as a polynomial $D(x)$ where each of the data bits are the coefficients for each term. The data polynomial $D(x)$ is divided modulo 2 by a predetermined generator polynomial $G(x)$ and a remainder $R(x)$ of this division is appended to the digital data word *d* as a cyclic redundancy check (CRC) character. The remainder, which is shorter than the original polynomial, is a unique number for each data word. The higher the order of the generator polynomial $G(x)$, the greater the probability of detecting an error, but the more difficult it is to implement the division in hardware and the greater the amount of bandwidth sacrificed to deliver the information.

The CRC included in a message is compared with the CRC character obtained at the receiving end by performing the same division. If the two CRCs agree, the message is assumed correct. If they disagree, the receiving terminal will take some appropriate action.

To show how the CRC is generated, let the digital data word *d* consist of L bits: $d = a_{L-1} \ldots a_1 a_0$, where $a_i = 0$ or 1. The (L - 1)-degree polynomial $D(x)$ is:

$$D(x) = a_{L-1}x^{L-1} + \ldots + a_1x^1 + a_0x^0 = \sum_{i=0}^{L-1} a_i x^i \qquad (1)$$

As previously discussed, the CRC may be a single character or r bits, where r < L. $D(x)$ is multiplied by $x^r$ as this is equivalent to shifting the message bits r places to the left. Let $G(x)$ be the "generator" or "checking" polynomial of degree r, whose coefficients are also 0 or 1. The shifted polynomial data $D(x)$ is divided by $G(x)$ obtaining:

$$\frac{x^r D(x)}{G(x)} = Q(x) + \frac{R(x)}{G(x)} \bmod 2 \qquad (2)$$

$$\frac{D(x) - R(x)}{G(x)} = Q(x) + 0 \qquad (3)$$

where:

$R(x) =$ the remainder (i.e., the CRC),
$Q(x) =$ the quotient, and
"mod 2" = the calculations are done in modulo 2

In modulo 2 arithmetic, the results of all additions and subtractions are the remainders of the "normal" sum or differences after they have been divided by 2; e.g., in modulo 2 arithmetic:

$1 + 1 = 0$
$1 + 1 + 1 = 1$

Note that no "carries" or "borrows" are generated from one position to the next.

From Eq. (2), $R(x) = x^r D(x) + Q(x)G(x) \bmod 2 \quad (4)$

A coded data word (i.e., the data) with the CRC appended is W(x) where:

$$w(x) = Q(x)G(x) = x^r D(x) + R(x) \bmod 2 \quad (5)$$

W(x) is of degree $r + L - 1$, and contains the original L message bits (the $x^r D(x)$ term) and r check bits (the R(x) term). Furthermore, W(x) is exactly divisible by G(x). The coefficients of W(x) is what is transmitted. On the receiving end, W(x) is also divided by G(x), and the remainder in this case must be 0; otherwise, if a remainder is generated, an error has occurred.

Hence, three steps are involved in the CRC and detection process:
1) Generation of the CRC by dividing the data polynomial by the generator polynomial to produce the CRC (remainder polynomial);
2) Transmission of the CRC with the data; and
3) Error checking -- The entire received polynomial, consisting of the transmitted data followed by the CRC, is divided by the generator polynomial. If the remainder is zero, then no error occurred. If the remainder is non-zero, at least one error occurred during transmission.

Some systems, notably FDDI, actually transmit the 1's complement of the remainder rather than the remainder itself. In such systems, the receiver then compares the calculated remainder of the transmitted word against an expected constant value and report an error if there is a mismatch. Such systems are more robust against spurious strings of zeros being added to the end of any message.

For example, if the data word, d, is 1010010001, then $D(x) = x^9 + x^7 + x^4 + 1$. If $G(x) = x^5 + x^4 + x^2 + 1$, modulo 2 division of $x^5 D(x)$ by G(x) is:

$Q(x) = x^9 + x^5 + x^3$ and $R(x) = x^4 + x^3$
$W(x) = x^{14} + x^{12} + x^9 + x^5 + x^4 + x^3$

and the transmitted data word with the CRC appended is:

```
1010010001    | 11000
original data | CRC bits
```

Parallel bit CRC processing, wherein a plurality of data bits are read in parallel and shifted in parallel, to generate an error checking code is well known. By shifting n bits in parallel, one shift in the parallel circuitry is equivalent to n shifts in a serial system. It is also known that in implementing the CRC generator circuitry, where a plurality of data bits are being processed in parallel, certain of the hardware elements may be shared. It is also well known that the CRC generating circuitry may employ a plurality of shift registers, used in conjunction with exclusive OR-type logic elements to generate the CRC since the data received is binary data.

U.S. Patent No. 3,703,705, entitled, "Multi-Channel Shift Register," issued to Patel on Nov. 21, 1972, and herein incorporated by reference, discloses a multi-channel feedback shift register circuitry for processing an input data bit stream in parallel to generate an error checking code according to Equation 4.

The input data bits are respectively received in parallel and the error code generating circuit is arranged according to the particular generator polynomial employed to generate the error check code. Patel teaches that for any polynomial G(x) with a degree of r, a parallel feedback shift register circuit can be generated which processes Y bits in parallel (where Y is $\leq$ r).

However, Patel does not teach or suggest how to read out the error check code generated for the last data byte received.

U.S. Patent No. 4,593,393, entitled "Quasi Parallel Cyclic Redundancy Check," issued to Mead on June 3, 1986, teaches that an error checking encoding and decoding circuit may receive a plurality of input bits in parallel and generate a CRC by processing the data in parallel. The bits are read into a first set exclusive-OR gates and its output is input into a second set of exclusive-OR gates. The output from the second set of exclusive-OR gates are input into a third set of exclusive-OR gates, where each set has eight exclusive-OR gates since 8 bits of data are processed in parallel. On a first clock pulse, the signals out of the third set of gates are transferred into flip-flops and on the second clock pulse, the signals are shifted from the first set of flip-flops to a second set of flips. The output from the two sets of flip-flops are coupled to AND gates where the signals are ANDed to produce the CRC signal. While the system generates a CRC by processing multiple bits in parallel, the system does not share hardware elements.

Similarly, U.S. Patent No. 4,498,174, entitled "Parallel Cyclic Redundancy Checking Circuit," issued to LeGresley on Feb. 5, 1985, shows a CRC encoding and decoding circuit where data bits are input in parallel and processed in parallel U.S. Patent No. 4,105,999, entitled "Parallel-Processing Error Correction System," issued to Nakamura on Aug. 8, 1978 also teaches a parallel CRC generator circuit where a plurality of data bits are received in parallel and the logic circuitry employed is arranged based upon the generator polynomial used to generate the CRC. However, neither parallel processing error code generating systems disclose how the CRC is read out of the shift register after the data sequence has been received.

An approach which may be employed to read out the stored error code signal is to "create a 4 deep by 8-bit wide shift register out of the storage elements by installing 2-input MUXes on the inputs of the top 24 storage devices. One of the two inputs to each MUX would come from the logic that had previously been wired into the input of the storage element. The other input would come directly from the output of the storage element 8 positions earlier. To read out the result, the input to these MUXes is changed. The disadvantages of this approach is that it requires 24 MUXes which take up room in an implementation, consume power, and add delay to the logic path, potentially limiting execution speed."

The present invention as defined in the independent claims may be briefly described with reference to a preferred embodiment:

A plurality of data information bits are input to a shift register and modulo 2 added to an input distribution matrix, B. The input distribution matrix B determines how an input data bit stream I will be added to a state transition matrix A where the current state information is stored to generate the next state information $S_{m+z}$.

The input distribution matrix B is comprised of a plurality of logic elements and shift registers which are configured based upon the generator polynomial G(x) employed to generate a cyclic redundancy error check code which is appended to the information data bit stream to be transmitted. The state transition matrix is also comprised of a plurality of logic elements and shift registers. In implementing the A and B matrices in hardware, the system makes use of the fact that the input distribution matrix B is related to the state transition matrix A in that the columns of the B matrix make up a proper subset of the columns of the A matrix.

In order to read the calculated error check code out of the storage registers, the data is shifted through the storage registers and a portion of the error check code is presented to a Z-bit wide x 2 input multiplexor. To further shift the remainder of the error check code without further modification requires that logical zero signals be applied to logical exclusive OR gates at the input to certain of the storage registers. The zeros may be forced by applying a logical zero signal to one input of each of a plurality AND gates at the output of the input distribution matrix or, by applying a logical zero signal to one input of each of a plurality AND gates at the input to the input distribution matrix. The number of AND gates required at the input to the B matrix is less than the number of AND gates at the output of the B matrix.

A primary object of the present invention is to provide a cyclic redundancy error code generating system which processes parallel data, shares common logic circuitry, and which provides means for reading out of storage during subsequent clock cycles, the generated error code without modifying it. The error check code is appended to the data word being transmitted.

These, and further objects and advantages of the present invention will be made clear or will become apparent during the course of the following description of the preferred embodiment of the present invention.

In the accompanying drawings:

Figure 1 is a diagram of a state transition matrix and an input distribution matrix for a generator polynomial of the preferred embodiment;

Figure 2 is a diagram of a state transition matrix and an input distribution matrix for a generator polynomial of the preferred embodiment wherein a plurality of data bits are received in parallel;

Figure 3 is a block diagram of an error check code generator system of the present invention for accessing an error check code in parallel;

Figure 4 is a block diagram of an alternate error check code generator system of the present invention; and

Figure 5 is a timing diagram corresponding to an error check code generated by the present invention.

In a serial realization of an n-bit CRC generator, each bit of state information is a function of the previous bit, the most significant bit, and the input bit according to the following Equation:

$$S_{j,\,m+1} = S_{j-1,m} + g_j \times (i_m + S_{n-1,m}) \quad (9)$$

where:

4

n = order of the generator polynomial

m = the number of bits processed

j = the position within the state variable S where $S_m = \{s_{0,m}, s_{1,m}, \ldots s_{n-1,m}\}$

$s_{j-1,m}$ = the $j-1^{th}$ bit of the current state variable $S_m$ before processing the $m^{th}$ bit;

$s_{j,m+1}$ = the $j^{th}$ bit of the state variable $s_{m+1}$ after processing the $m^{th}$ bit;

$g_j$ = the $j^{th}$ coefficient of the generator polynomial $G(x)$;

$i_m$ = the $m^{th}$ input bit;

+ = signifies a logical EXCLUSIVE-OR operation; and

x = a logical AND operation.

Equation 9 is true for $0 \leq j \leq n-1$ where $s_{-1,m}$ is defined to be 0.

Since Equation 9 actually represents n separate equations, it can be expressed in matrix form as:

$$S_{m+1} = A \times S_m + B \times i_m \quad (10)$$

where:

$S_m$ = the current state information (i.e., the state value before processing the $m^{th}$ input bit $i_m$). $S_m$ is the remainder polynomial for the data stream up to, but not including a previously received data $i_m$ (i.e., up through $i_{(m-1)}$).

A = the state transition matrix. The state transition matrix determines the effect that the current state $S_m$ has on the subsequent state, $S_{m+1}$. It is directly related to $G(x)$.

B = input distribution vector. The input distribution vector describes the effect of that input data, $i_m$, on the subsequent state, $S_{m+1}$. It is also related to $G(x)$.

$i_m$ = $m^{th}$ input data bit of the input data stream $I_{0(L)}$.

Assuming there are L bits in the data stream $I_L$, the entire bit stream is comprised of bits $i_0$ - $i_{L-1}$. The error check code (i.e., the final state of the error code generator system) is $S_L$. Where, for m = L, $S_L = S_m$.

At the beginning of the check code generation process, the state bits S are set to some predetermined value, $S_0$. That value is often zero; however, in the preferred embodiment (and in FDDI) it is all ones. Each bit of the data stream causes a change in state according to Equation 10. When all L of the input bits ($i_0 \ldots i_{L-1}$) have been processed, the state value $S_L$ is equal to the remainder polynomial (or error check code).

The A matrix is comprised of a plurality of rows and columns wherein the $n-1^{st}$ column is made up of the coefficients ($g_j$) of the generator polynomial $G(x)$ where, for $0 \leq j \leq n-1$:

$$a_{j,n-1} = g_j \quad (11)$$

The remainder of the A matrix is filled with zeroes except for an off-diagonal set of ones. For $0 \leq j \leq n-1$ and $0 \leq k \leq n-2$:

$$\text{if } j = k-1, \text{ then } a_{j,k} = 1; \text{ otherwise } a_{j,k} = 0 \quad (12)$$

In Equations 11 and 12, $a_{j,k}$ is the element in the $j^{th}$ row of the $k^{th}$ column of matrix A and $a_j$ is the coefficient of the $j^{th}$ term in the generator polynomial $G(x)$.

The state transition matrix A is an $n \times n$ matrix of coefficients (or elements), where n is the largest power in the generator polynomial $G(x)$. Similarly, the elements ($b_j$) of the input distribution vector, B, are also directly related to the generator polynomial by:

$$b_j = g_j \quad (13)$$

In performing multiplication between two matrices, each term $z_{j,k}$ in the resulting matrix Z is formed by calculating the cross product of the $j^{th}$ row of the first matrix operand and the $k^{th}$ column of the second matrix operand. The cross product is calculated by logically ANDing together the pairs of corresponding elements and then logically EXCLUSIVE-ORing those results together. If one of the operands is a scalar rather than a matrix, then the product is formed by multiplying each element of the operand matrix by the scalar.

For addition between two matrices or vectors, the elements of the resulting matrix or vector is formed by logically EXCLUSIVE-ORing together the corresponding elements of the two matrices or vectors.

Hence, an error check code generating system utilizes a generator polynomial employed G(x), a received data sequence $I_{0(L)}$, a distribution matrix B, a state transition matrix A, and current state information S , to generate an error check code $S_L$ corresponding to the entire bit stream $I_{0(L)}$).

For each data bit $i_m$ received, the next state $S_{m+1}$ is calculated and replaces the prior $S_m$ value and becomes the current state information. Hence, generating the next state information for a sequence of data is an iterative process.

The cyclic redundancy error check code generator of the present invention may be used in conjunction with a data transmission network, such as the Fiber Distributed Data Interface (FDDI), to determine the integrity of a received data transmission.

The Fiber Distributed Data Interface (FDDI) protocol is an American National Standards (ANS) data transmission standard which applies to a 100 megabit/second token ring network that utilizes an optical fiber transmission medium. The FDDI protocol is described in "FDDI-an Overview," Digests of Papers IEEE Computer Society Int'l Conf., Compcon '87, Jan, 1987, which is herein incorporated by reference.

The FDDI protocol is intended as a high performance interconnection among computers as well as among computers and their associated mass storage sub-systems and other peripheral equipment. Information is transmitted on an FDDI ring in "frames" that consist of a sequence of 5-bit data characters or "symbols." Information is typically transmitted in symbol pairs or "bytes." Tokens are used to signify the right to transmit data between stations.

In FDDI, a particular generator polynomial G(x) is employed to generate an cyclic redundancy error check code. The FDDI generator polynomial and a sample implementation for generating an error check code polynomial in series is provided in FDDI Media Access Control (MAC-M), X3T9.5/88-139 Rev. 2, June 1, 1989, and is herein incorporated by reference.

In FDDI, the generator polynomial G(x) is:

$$G(x) = X^{32} + X^{26} + X^{23} + X^{22} + X^{16} + X^{12} +$$
$$X^{11} + X^{10} + X^8 + X^7 + X^5 + X^4 + X^2 + X + 1 \quad (14)$$

Since the highest order in the preferred generator polynomial in Equation 14 is 32, n = 32. The values of the coefficients in the state transition matrix element are determined by the generator polynomial G(x) and the number of data bits to be processed in parallel. (Equations 11, 12).

The next state of the check code generator $S_{m+1}$ is generated in series according to the following matrix notation:

$$S_{m+1} = A \times S_m + B \times i_m \quad (15)$$

where $S_m$ is the state of the generator before the application of input bit $i_m$, $S_{m+1}$ is the state of the error check code generator polynomial after the $m^{th}$ bit has been processed (i.e., the next state information $S_{m+1}$), A is the n x n state transition matrix describing the transformation, and B is the n x 1 vector describing the effect of the $m^{th}$ input bit on the result.

The state transition matrix A is directly related to the generator polynomial G(x) and the input distribution vector B is identical to column n - 1 of the A matrix. For the preferred generator polynomial in Equation 14 A is a 32 x 32 matrix and B is a 32 x 1 vector.

The application of the next bit, $i_{m+1}$, results in $S_{m+2}$ as follows:

$$S_{m+2} = A \times S_{m+1} + B \times i_{m+1} \quad (16)$$

Substituting Equation 15 into Equation 16 results in:

$$S_{m+2} = A \times (A \times S_m + B \times i_m) + B \times i_{m+1} \quad (17)$$

or:

$$S_{m+2} = A^2 \times S_m + A \times B \times i_m + B \times i_{m+1} \quad (18)$$

or:

$$S_{m+2} = A^2 \times S_m + B_2 \times I_{m(2)} \quad (19)$$

where $A^2$ is the square of the A matrix, $B_2$ is an n x 2 matrix made up of the vectors B and A x B, and $I_{m(2)}$ is the 2 x 1 vector made up of the two input bits starting with $i_m$. In general $I_{m(z)} = (i_{m+z-1}, i_{m+z-2}, \ldots i_m$ where $I_{m(z)}$ is a z x 1 vector.

By continued application and extension, for an 8-bit input (z = 8):

$$S_{m+8} = A^8 \times S_m + B_8 \times I_{m(8)} \quad (20)$$

where $S_{m+8}$ is the state of the generator after 8 input bits are processed in parallel, $A^8$ is the A matrix raised to the 8th power, $B_8$ is the 32 x 8 matrix made up of the vectors B, and A x B, A x A x B, etc., and $I_{m(8)}$ is the 8 x 1 vector made up of the eight input bits starting with $i_m$.

By creating the $A^8$ matrix and the $B_8$ matrix according to Equations 11 and 13, and by observing the two matrices, it is apparent that the 8 highest columns of the $A^8$ matrix are identical to the 8 columns comprising the $B_8$ matrix. The $B_8$ matrix is identical to 8 columns of the $A^8$ matrix because the operations that take place on A to form the $A^8$ matrix are the same as the operations that take place on B to form the $B_8$ matrix.

The physical realization of the error check code generator of Equation 20 in hardware operates on eight input bits at a time. By the nature of the exclusive OR operation and by observing the similarities between the $B_8$ matrix and the $A^8$ matrix, the input bits $I_m$ may be exclusive OR-ed with the 8 most significant bits of $S_m$ before the $B_8$ matrix is applied. By doing so, the hardware with which the 8 columns in the $A^8$ matrix are implemented may be eliminated to avoid duplication of hardware elements.

Observing that the leftmost 8 columns of $A^8$ are exactly identical to $B_8$, a new vector, $T_m$, may be created according to:

$$t_{j,m} = s_{j,m} - i_{j-24} \quad (21)$$

where:

$t_j =$ the $j^{th}$ element of $T_m$;

$s_{j,m} =$ the $j^{th}$ element of S; and

$i_{j-24} =$ the j-24$^{th}$ element of the input vector I and is equal to zero for all subscripts less than 0.

Thus, Equation 20 may be reduced to:

$$S_{m+8} = A^8 \times T_m \quad (21)$$

The realization of Equation 21 in hardware requires the following:

1. A set of 32 storage elements arranged into 4 ranks of 8 elements each for holding the state variable, $S_m$.

2. A set of 8 EXCLUSIVE-OR gates to combine the outputs of the top 8 storage elements with the 8 inputs, forming the top 8 bits of the $T_m$ vector. The outputs of these 8 gates feed the B-Matrix.

3. A set of 24 EXCLUSIVE-OR gates corresponding to the 24 off-diagonal ones in the $A^8$ matrix. The outputs of these gates feed the inputs of the top 24 storage elements. One input of each of these gates comes from the storage element in the corresponding position of the next lower rank; i.e., from the 8th lower storage element. The other input to the gate comes from the B-Matrix.

4. A set of EXCLUSIVE-OR gates called the B-Matrix. The inputs to the B-Matrix come from the top 8 bits of the $T_m$ vector. 24 of the outputs of the B-Matrix go to the EXCLUSIVE-OR gates in front of the top 24 storage elements and the remaining 8 outputs go to the bottom 8 storage elements. The particular combination of EXCLUSIVE-OR gates within the B-Matrix going to a particular output is determined by the presence of ones along the corresponding row in the left 8 columns of the $A^8$ matrix.

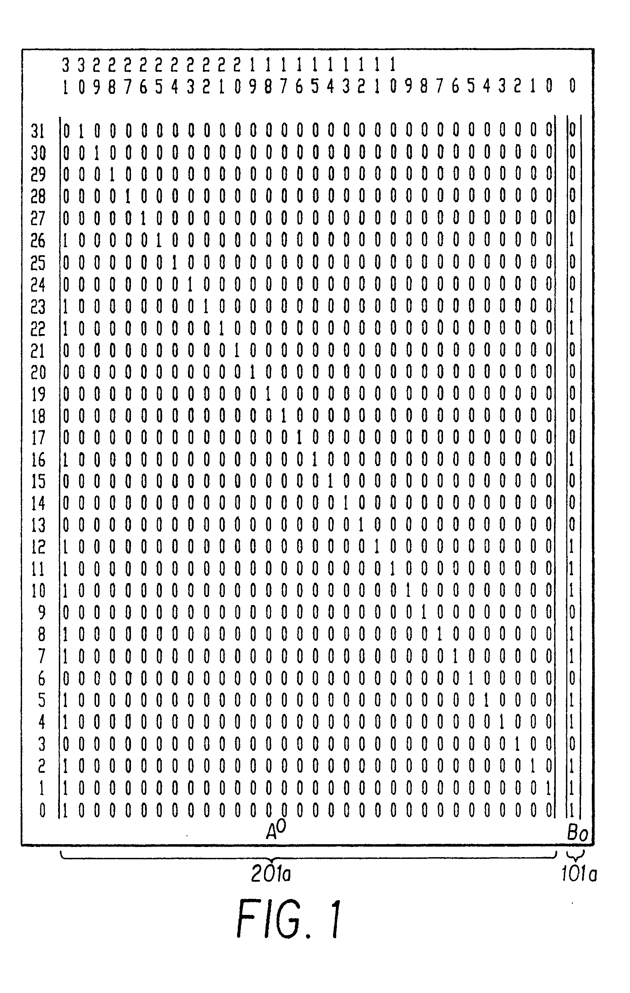

Referring to Figure 1, a state transition matrix ($A^0$)101a for an n order generator polynomial of Equation 14 and a corresponding input distribution vector ($B_0$) 201a is illustrated.

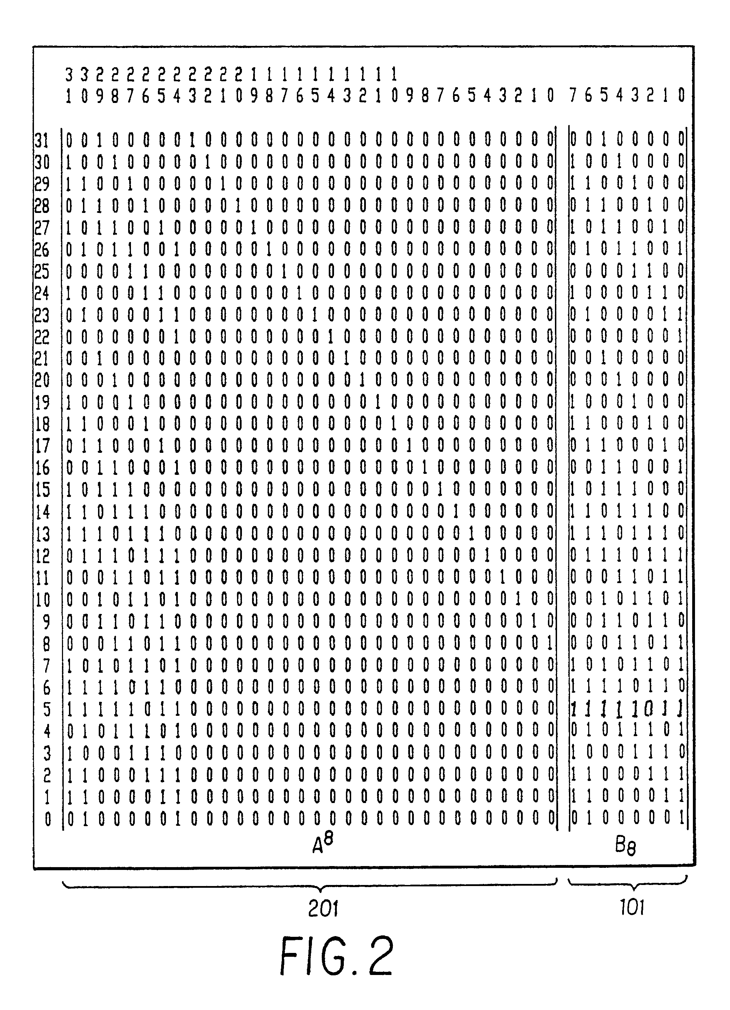

Referring to Figure 2, a state transition matrix $A^z$ 101 for the n - order generator polynomial of Equation 14 is illustrated (n = 32). In particular, the state transition matrix 101 is designed for a system where 8 bits of data are received and processed in parallel, (z = 8) and the state transition matrix 101 is denoted as the "$A^8$ matrix."

The $B_z$ matrix 201 is identical to the Z highest columns in the state transition matrix 101. In particular, $B_z$ is identical to columns n-1 through n-z of the A matrix 101.

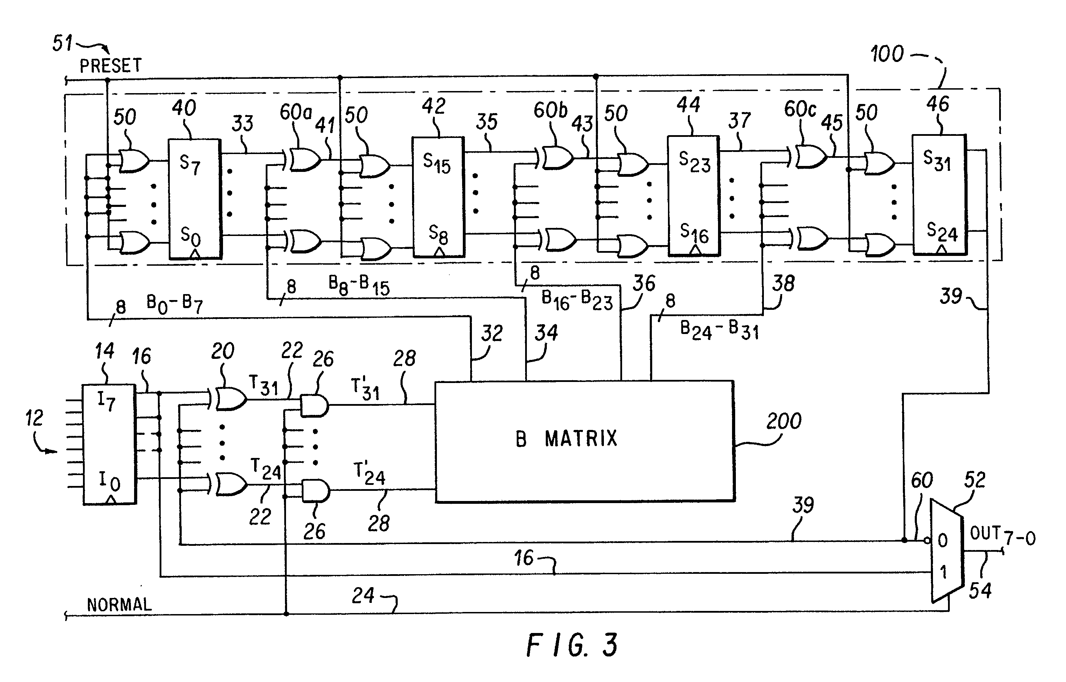

Referring to Figure 3, an error check code generating system 300 for implementing Equation 21 in hardware, where 8 bits are processed in parallel (z = 8), and common hardware elements are shared, is illustrated. It is recognized that those skilled in the art may arrive at various other systems for generating an error check code in accordance with Equation 20, or for generating an error check code where the error check code corresponds to the remainder terms which are stored in a storage element after the data sequence has been processed.

The system 300 includes an input storage register 14, an input distribution matrix element 200 and a state transition matrix element 100. In implementing Equation 20 in hardware, the logic elements used to implement the A matrix 101 which are the same as those used to implement the B matrix 201 may be shared.

By sharing hardware elements the overall size of the system 300 is reduced since fewer components are necessary. The state transition matrix element 100 and the input distribution matrix element 200 are both comprised of logic elements which implement the matrices in hardware.

Before any input data byte signals 12 are received, a plurality of state storage registers 40, 42, 44, 46 in the state transition matrix element 100 are preset by a PRESET control 51 to all ones by inserting a plurality of sets of logical OR gates 50 at the input of the state storage registers 40, 42, 44, 46. Hence, when the system 300 is preset, the state storage registers 40, 42, 44, 46 store a plurality of logic 1 signals and generate a plurality of current state signals 33, 35, 37, 39 which are also all logic 1's.

A parallel input data signal ($I_z$) 12 comprised of z bits, defined as a data byte, is received by an input register 14 which has z input ports. A plurality of data bytes received over a plurality of clock cycles may comprise the data sequence $I_{0(L)}$ for which the error check code $S_L$ is being generated. $I_{0(L)}$ is comprised of bits $i_0 \ldots i_{L-1}$. In the preferred embodiment, the input data byte signal 12 is 8 bits wide $I_0$-$I_7$ and therefore the input register 14 is an 8 bit storage register. Only one clock is needed because all of the input bits $i_{m+7}$ - $i_m$ of the data byte 12 are read in parallel.

A control signal 24 which controls a multiplexor (MUX) 52 issues a logic high signal or a "1" when the system 300 is receiving an input data byte 12 ($i_{m+7}$ , ... $i_m$). The control signal 24 may either be a logic high or a logic low signal. The MUX 52 is an z-bit wide multiplexor. In the preferred embodiment, since eight bits are processed in parallel the MUX 52 is an 8-bit wide MUX. Similarily, since the MUX 52 selects between 2 input (signal 16 or signal 39) the MUX is an 8-bit 2 input wide MUX 52.

The input register 14 is rising edge sensitive and upon receiving a rising edge clock signal (not illustrated), the input register 14 stores the data byte signal 12 received ($i_{m+7}$ ... $i_m$) and it also outputs a data byte signal 16 having the same value as the data signal 12 received.

The data byte signal 16 is modulo 2 added in parallel, via a plurality of exclusive-OR gates (XOR) 20, to a last one of a plurality of a current state remainder signals 39 ($S_{24-31}$), where signals 39 are the top eight bits of $S_m$ ($S_{31,m}$ - $S_{24,m}$). In general, the last current state signal 39 corresponds to bits N-1 through N-Z of the current state signal $S_m$. The XOR gates 20 sum each bit in the signals 16, 39 together and a first summed Z-bit parallel signal 22 is generated. The first summed signal 22 is $T_{31,m}$ -$T_{24,m}$.

Both signals 39, 16 are added together to save logic elements because, according to Equation 14, both signals 16, 39 are multiplied by the input distribution matrix 200. The signals 16, 39 may be added together first before being multiplied. As will be discussed below, the first summed signal 22 is modulo 2 multiplied with the control signal 24 to generate a Z-bit controlled sum signal 28 where, in the preferred embodiment the controlled sum signal 28 is $T'_{31,m}$ - $T'_{24,m}$. The modulo 2 multiplication is accomplished by a plurality of logical AND gates 26 which each logically AND together the control signal 24 and each bit of the first summed signal 22.

If the control signal 24 is a logic 1, then the Z-bit controlled sum signal 28 is identical to the Z-bit parallel first summed signal 22. If the control signal 24 is a 0, then the controlled sum signal 28 is a 0.

The Z-bit parallel controlled sum signal 28 is input to the input distribution matrix element 200 where it is multiplied by the input distribution matrix ($B_8$ matrix) 201. The remainder terms generated by the B matrix multiplication comprise an N-bit parallel distribution signal $B_0$ - $B_{31}$. The B matrix 201 calculates the 8 highest columns of the $A^8$ matrix and presents those 32 output signals (distribution signals 32, 34, 36, 38) as the 4-sets of 8 bit distribution signals. The distribution signals 32, 34, 36, 38 are a partial sum in that they represent the cross product of the highest 8 bits of the T matrix with the highest 8 columns of the $A^8$ matrix (i.e., columns 31-24).

The input distribution matrix 201 converts the Z-bit parallel controlled sum signal 28 into an N-bit parallel distribution signal $B_0$ - $B_{31}$. In the preferred embodiment, a first one of the parallel distribution signals corresponds to bits 0-7 ($B_{0-7}$) of the distribution signal and is herein referred to as "the first distribution signal 32"; a second one of the signals corresponds to bits 8-15 ($B_{8-15}$) and is herein referred to as "distribution signal 34"; a third one of the parallel signals corresponds to bits 16-23 ($B_{16-23}$) and is herein referred to as "distribution signal 36"; and a fourth one of the parallel signals corresponds to bits 24-31 ($B_{24-31}$) and is herein referred to as "the last distribution signal 38".

8

At any given clock stroke, $S_m$ enters the state storage registers 40, 42, 44, 46 and $i_m$ enters the input storage register 14. After that clock stroke and the normal propagation delays, the values of $S_{m+8}$ are calculated and presented to the input of storage registers 40, 42, 44, 46 so that on the next clock stroke, $S_{m+8}$ is clocked into registers 40, 42, 44, 46.

Assuming that $i_{m(8)}$ is stored in the input storage register 14 and $S_m$ is stored in registers 40, 42, 44, 46, then during a particular clock cycle, $S_{31,m}$ - $S_{24,m}$ (the last of the current state remainder signal 39) is XORed, by XOR gates 20, with $i_{m+7}$ - $i_{m+0}$ (the data byte signal 16) to generate $T_{31,m}$ - $T_{24,m}$ (the first summed signal 22). In normal operation, when data bytes $i_m$ are being received and the control signal 24 is a logic 1, AND gates 26 AND signal 22 and signal 24 such that the values of $T_{31,m}$ - $T_{24,m}$ are repeated at the output of the AND gates 26 as controlled sum signals 28 ($T'_{31}$ - $T'_{24}$). The controlled sum signals 28 are input to the B matrix 200.

During a particular clock cycle, all of the distribution signals 34, 36, 38 generated in that clock cycle, except for the first distribution signal 32, are modulo 2 added by logical exclusive OR gates (XOR) 60a, 60b, 60c respectiviely with a plurality of current state remainder signals $S_m$ 33, 35, 37 (generated in the previous clock cycle but stored in the registers at the end of that clock cycle) read out of the plurality of state transition storage registers 40, 42, 44.

The first distribution signal 32, which represents the 0 - 7 rows of the 8 highest columns of the $A^8$ matrix, is presented directly to storage register 40 (since the preset signal is 1). The highest 8 columns are identical to the $B_8$ matrix.

The second distribution signal 34, which is the 8 - 15 rows of the highest 8 columns of the $A^8$ matrix is XORed, via a plurality of XOR gates 60a, with the current state remainder signal $s_{0,m}$ - $s_{7,m}$ 33 output by register 40. The remainder terms 41 generated by this matrix multiplication is $s_{8,m+8}...s_{15,m+8}$. The remainder terms 41 are available at the input of register 42 but will not be stored into the register 42 until the next clock cycle. (On the next clock cycle $s_{8,m+8}...s_{15,m+8}$ are stored into register 42.

Similarly, the third distribution signal 36 is the 16-23 rows of the highest 8 columns of the $A^8$ matrix. The third distribution signal is XORed, via a plurality of XOR gates 60b, with the current state remainder signal 35 $s_{8,m}$ - $s_{15,m}$ output by register 42. The remainder terms 43 generated by this matrix multiplication are $s_{16,m+8}...s_{23,m+8}$. They are available at the input of register 44 but, again, are not stored into the register 44 until the next clock cycle. (On the next clock cycle $s_{16,m+8}...s_{23,m+8}$ are stored into register 44.

The last distribution signal 38 represents the value of the highest 8 rows (rows 24-31) of the highest 8 columns of the $A^8$ matrix. The last distribution signal 38 is XORed, via a plurality of XOR gates 60c, with the current state remainder signal 37 output by register 44. The current state remainder signal 37 is $s_{16,m}$ - $s_{23,m}$. The remainder terms 45 generated by this matrix multiplication are $s_{24,m+8}...s_{31,m+8}$ and they are available at the input of last state register 46 but, on the next clock cycle $s_{24,m+8}...s_{31,m+8}$ are stored into register 46.

The clock stroke after that which presented the last data byte $I_{L-8}$ to the generator system 300, the storage elements 40, 42, 44, 46 of the generator 300 contain the remainder terms or error check code $S_L$ for the data sequence $I_{0(L)}$. There are several approaches that may be employed for appending the error check code to the data sequence, $I_{0(L)}$. Each of the approaches involve 1) using an eight 2-input MUXes to select the source of the output from either the 8 input bits 16 or the top 8 storage elements 39 and 2) changing the control signal 24 input to that MUX 52 after the last data byte $I_{L-8}$ has been clocked into the data storage register 14.

The first approach places a two-input MUX at the input of each of the top 24 outputs of storage elements 42,44, 46. The MUX is controlled with the same signal that controls the 8 output MUXes. These 24 MUXes would choose either the EXCLUSIVE-OR gates 60a, 60b, 60c that normally feed the input to the storage elements or the output of the corresponding storage element in the next lower rank. This approach allows the data to shift through the storage elements on the subsequent clock strokes.

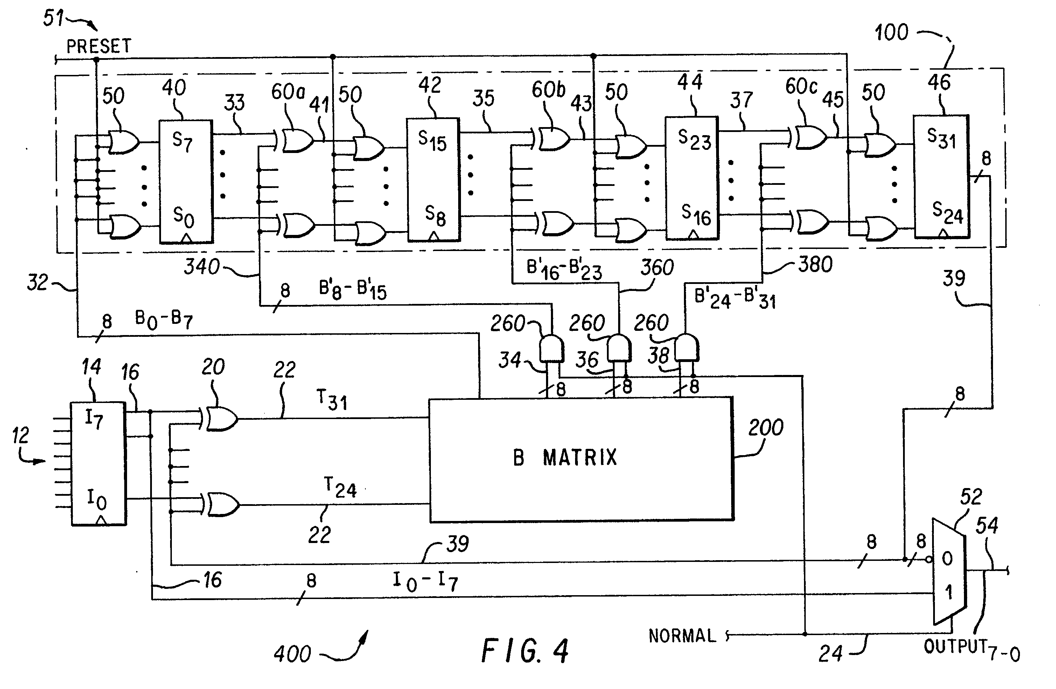

The second approach (shown in Figure 4) makes use of the fact that the 24 EXCLUSIVE-OR gates already tie the top 24 outputs of storage elements 42, 44, 46 to the corresponding elements in the next lower rank. By interrupting the 24 lines 32, 34, 36 from the B-Matrix that feed the other inputs to those EXCLUSIVE-OR gates 60a, 60b, 60c with 2-input AND gates, and by controlling the second input of each of those AND gates with the same signal 24 that controls the output MUXes, we can force a zero onto that input of the 24 EXCLUSIVE-OR gates thereby allowing them to pass information through without modification.

The third approach, which is the approach employed in the preferred embodiment (shown in Figure 3), makes use of the fact that forcing the highest 8 bits of the T vector to zero also forces the outputs of the B-Matrix to zero, thereby having the same effect as the 24 2-input AND gates in the second approach. However, the third approach is more efficient since it only requires 8 2-input AND gates.

The contents of the state storage registers 40, 42, 44, 46 are read out in parallel as the N-bit current state signals 33, 35, 37, 39 forming $S_m$. Each of the state storage registers 40, 42, 44, 46 outputs Z-bits of the N-bit current state signal $S_m$. The remainder terms generated by the matrix multiplication 41, 43, 45 are stored in a plurality of the state storage registers 42, 44, 46 and the first distribution signal 32 stored in register 40 are the N-bit next state signal $s_{m+8}$.

As previously discussed, the first distribution signal 32 is stored in parallel in the first one of the Z-bit state storage register 40 without being logically XOR-ed with Z-bits of the current state remainder signal, $S_m$. Hence, the N-bit parallel distribution signal 32, 34, 36, 38 is modulo 2 multiplied with N-Z rows of the state transition matrix 101. There is no need to XOR the first distribution signal 32 because, as previously discussed, it corresponds to the bottom z rows of the state transition matrix (rows 0-7) 201.

Since the first z rows in the bottom z columns of the A matrix 101 are logic 0 (Figure 2), XOR-ing (to perform a modulo 2 multiply) 0 terms with the first distribution signal 32 results in the first distribution signal 32 being unchanged. Hence, in order to save logic elements, it is not necessary to provide a logical XOR-gates at the input to the first state storage register 40.

In the preferred embodiment, the state transition matrix element 100 is a 32 x 32 matrix which is realized in hardware using a plurality of logical XOR gates 50. There is one logical XOR gate 50 for each bit of the parallel 8-bit distribution signals 34, 36, 38 (excluding the first distribution signal 32) that are received by the state transition matrix element 100. The state transition matrix element 100 also includes a 4-8 bit state storage register 42, 44, 46, 48 for simultaneously storing the 24 remainder terms generated by the matrix multiplication and the first distribution signal 32. Each of the state storage registers 40, 42, 44, 46, 48 outputs 8-bits of the 32 bit state signal 33, 35, 37, 39, respectively.

The input distribution matrix element 200 is a 32 x 8 matrix which is also implemented in hardware using conventional techniques, such as a plurality of logical exclusive OR elements (not illustrated). In the preferred embodiment, the distribution matrix element 200 is configured similar to the state transition matrix element 100, however, in the preferred embodiment, it does not include storage registers.

The off diagonal of 1's section of the state transition matrix 101 is implemented in hardware by XOR-gates, where the 1st bit position is XORed with the 9th bit position, the 2nd bit position is XORed with the 10th bit position, the 3rd bit is XORed with the 11th bit position, etc. such that per clock cycle, an 8-bit matrix multiply and register shifting occurs. The remainder terms stored in the state register 40, 42, 44, 46 correspond to the next state information $S_{m=8}$ for the sequence of data bits received.

The process is repeated for the subsequently received data bytes.

Thus, during one clock cycle, the next state information for one or a plurality of data bytes received (over one or a plurality of clock cycles, respectively) is generated and during the next clock cycle it is stored in the state storage registers 40, 42, 44, 46. (The next state information is cumulative for the data bytes received.) In the preferred embodiment, it takes several clock cycles to read out of the state storage registers 40, 42, 44, 46 the error check code $S_L$ after the entire data sequence $I_{0(L)}$ has been received.

The number of clock cycles is equal to the number of bits in the remainder polynomial divided by the number of bits being processed in parallel. This, in the preferred embodiment, processing the 32 bit remainder 8 bits at a time requires 4 clock cycles to shift out all of the remainder terms.

The signals currently stored in the state storage registers 40, 42, 44, 46 after all of the data bytes have been received are said to have been generated in the "last clock cycle" or Cycle 0. Cycle 0 is the clock cycle which completes the generation of the error check code.

During the last clock cycle (cycle 0), the last input data sequence byte 12 in the data sequence is output as the data byte signal 16; the data byte signal 16 is read out as the system output signal 54; and the remainder terms forming the error check code are presented at the input of the state registers 40, 42, 44, 46.

During the next four clock cycles (Cycle 1 - Cycle 4) when no further valid data is received, the error check code is read out of the registers 40, 42, 44, 46.

The first clock cycle (Cycle 1) is the first clock cycle when no valid data is received. The control signal 24 becomes a logic low or zero and switches the MUX 52 to a 0, thereby causing the last state transition remainder signal 39 to be output as the system output signal 54. (When the data bytes 12 were being received the control signal was a logic high which controlled the MUX 54 to output the data byte signal 16.) The last state transition remainder signal 39 is the first eight bits of the error check code stored in register 46 ($S_{31}$ - $S_{24}$). The first eight-bits of the error check code terms are appended to the data sequence 54 output by the MUX 52 during the previous clock cycles.

The non-data signals received by the system during the clock cycles (Cycles 1-4) when the error check code terms are read out, continue to be XOR-ed with the last state signal 39. However, the first summed signals 22 generated are then logically ANDed with the logic zero control signal 24 and, by definition, the resulting controlled sum signals 28 generated are a logic 0. Hence, the signal 28 input to the input distribution matrix element 200 is a logic zero signal so the distribution signal 32, 34, 36, 38 generated during these 4 clock cycles are a logic zero.

By XOR-ing the contents of state storage registers (i.e. error check code terms) with the logic 0 distribution signals 28, the error check values stored in the state storage registers 40, 42, 44, 46 are preserved as they are successively shifted through the intermediate bank of storage registers 42, 44 to the last register 46.

In particular, during Cycle 1, by XOR-ing the contents of state register 44 (i.e. error check code terms $S_{16}$ - $S_{23}$) with the logic 0 distribution signals 28 it is essentially transferred or shifted from register 44 to the last state register 46. The contents of the first and second state storage registers 40, 42 (i.e. error check code terms $S_0$ - $S_7$ and $S_8$ - $S_{15}$) are also shifted to the next state shift register 42, 44, respectively, since the corresponding current state signals 33, 35 are XOR-ed with the corresponding logic zero distribution signals 34, 36.

During the second clock cycle, Cycle 2, the next eight bits of the error check code, which corresponds to $S_{16}$ - $S_{23}$ are output from register 46 since they had been shifted into register 46 during Cycle 1. The signal 39 is output as the system output signal 54 since the control signal 24 is still a logic low. The shifting process continues such that the $S_8$ - $S_{15}$ are stored in register 46 and $S_0$ - $S_7$ are stored in register 44.

During the third clock cycle, Cycle 3, the 8th - 15th error check code terms are read out of the last register 46 as signal 39 and the inverse of signal 39 is the system output signal 54. During the fourth clock cycle, Cycle 4, the 0 - 7th error check code terms corresponding (originally stored in $S_0$ - $S_7$ during Cycle 0) to are read out of the last state shift register 46 and its inverse is output as the system output signal 54.

When signal 39 is selected to be output as the system output signal 54 it is inverted by an invertor 60 at the front end of the MUX 52. The signal 39 is inverted in the preferred embodiment because FDDI specifies that the inverted bits, rather than the uninverted bits, of the remainder polynomial accompany the data bits in the message.

Referring to Figure 4, in an alternate arrangement 400, instead of positioning the Z - logical AND gates at the inputs of the distribution matrix element 200, logical AND - gates 260 may be located at the output of the distribution matrix element 200 such that 24 of the 32 bits of the distribution signal 32, 34, 36, 38 are logically AND-ed with the control signal 24. The AND-gates 260 generate a controlled Z-bit distribution signals 340, 360, 380 such that when the control signal 24 is a logic zero, the plurality of controlled distribution signals 340, 360, 380 are a logic zero; otherwise they are identical to the corresponding distribution signals 34, 36, 38. Hence, AND gates 260 serve the same function as the AND gates 26 in system 300 (Figure 3).

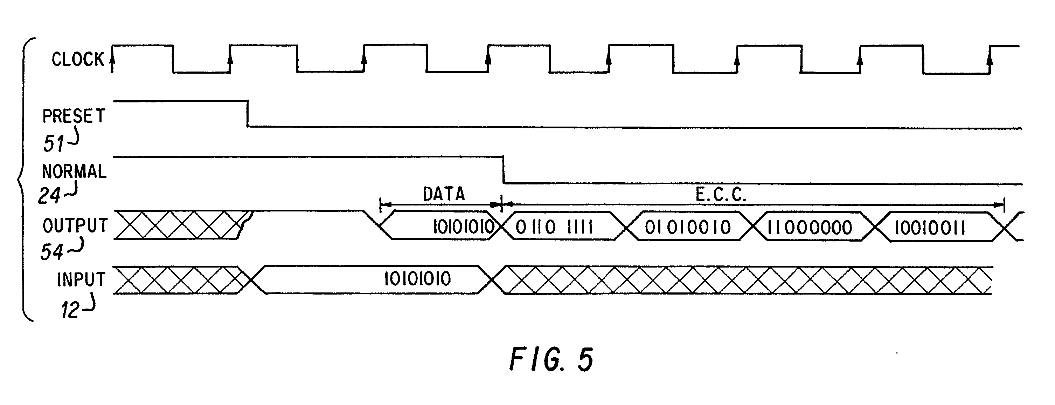

Referring to Figure 5, a timing diagram for an error check code (ECC) generated by the system 300, 400 is illustrated. Initially, the PRESET signal 51 is a logic high. The control signal 24 is high, and remains high, while the data sequence (10101010) is received by the system. When the control signal 24 is high, the data byte received during a particular clock cycle is output. After the data sequence (10101010) has been received, the control signal 24 changes to a logic low state (or zero level) and during successive clock cycles (4 cycles) the error check code (01101111 01010010 11000000 10010011) corresponding to the data sequence (10101010) received is successively read out of the storage registers (40, 42, 44, 46) and appended to the previously output data byte(s) (10101010).

It is believed necessary to initialize or "zero" the signals that are input to (or output from (system 400 in Figure 3)) the distribution matrix element 200 so that the error check code stored in the state storage registers 40, 42, 44 can be read out without being altered during the subsequent clock cycles. If the distribution signals 34, 36, 38 had not been zero signals then, during Cycles 1-4, the error check code terms stored in the state registers 40, 42, 44 would have been altered (having been XOR-ed with distribution signals 34, 36, 38 generated for non-data signals), and the error check code terms read out would not be the error check code corresponding to the data sequence previously received.

Having thus described the invention, it is recognized that those skilled in the art may make various modifications or additions to the preferred embodiment chosen to illustrate the invention without departing from the spirit and scope of the present contribution to the art. Accordingly, it is to be understood that the prosecution sought and to be afforded hereby should be deemed to extend to the subject matter claimed and all equivalents thereof within the scope of the invention.

## Claims

1.  A system for reading out a group of remainder polynomial terms generated by the system and stored in a plurality of storage means, wherein the remainder polynomial terms are generated according to a generator polynomial and a sequence of data bytes successively received by the system, comprising:

A) a control signal having a first or a second logic state associated therewith;

B) means responsive to the control signal for generating a storage control signal having a first logic state when the control signal has the first logic state; and

C) a plurality of successively arranged storage means for storing in sequence and in parallel groups of the remainder polynomial terms

wherein the storage means is responsive to the storage control signal such that when the storage control signal is the first logic state, the groups of remainder polynomial terms are sequentially transferred to a successive storage means without modification and the remainder polynomial terms in the last of the successively arranged storage means are output by the system.

2. The system of Claim 1, wherein the means for generating the storage control signal includes a plurality of logical AND-gate elements.

3. The system of Claim 1, wherein the first logic state is a logic zero.

4. The system of Claim 2, wherein each of the storage means further includes:

D) a plurality of logical exclusive-OR gate elements at the output of certain of the storage means wherein the logical exclusive OR gate elements which each receive the storage control signal having the first logic state as a first input signal and each receives one of the remainder polynomial terms transferred from a previous storage means as a second input signal and each generates an output signal that is identical to the remainder polynomial terms received when the storage control signal is the first logic state; and

means for sequentially transferring the output signals to the successful storage means.

5. A system for generating an error check code signal ($S_L$) comprised of a plurality of error check code terms to be appended to a data sequence ($I_{0(L)}$) according to a generator polynomial having a plurality of coefficient terms, a distribution matrix ($B_z$) having at least one column associated therewith, and a state transition matrix ($A_z$) having a predetermined number of columns associated therewith, wherein the state transition matrix and the distribution matrix are related to the generator polynomial and the distribution matrix columns are a subset of the state transition matrix columns, and the data sequence ($I_{0(L)}$) is arranged in a sequence of data bytes having a predetermined (z) number of data bits the system comprising:

A) first means for sequentially receiving the data bytes;

B) first means for modulo 2 multiplying the distribution matrix ($B_z$) with a received data byte ($I_{m(z)}$) to generate a plurality of distribution signals;

C) second means for modulo 2 multiplying the state transition matrix $A^z$ with the error check code signal corresponding to the sequence of data bits previously received ($S_m$) to generate a plurality of state signals;

D) means for modulo 2 adding the distribution signals and the state signals to generate the error check code signal ($S_{m+z}$) corresponding to the data bits (m + z) received;

E) second storage means for storing the error check code signal generated by Element E, wherein the third storage means includes a plurality of successively arranged storage elements for sequentially storing groups of the error check code terms in parallel wherein the second storage means is responsive to a storage control signal;

F) means for iteratively utilizing Elements A-E above to generate the error check code corresponding to the data sequence in accordance with the equation

$$S_{m+z} = A^z * S_m + B_z * I_{m(z)}$$

for each data byte received such that for each iteration $S_{m+z}$ replaces $S_m$ such that when all of the data bytes have been received, $S_{m+z}$ is the error check code signal corresponding to the data sequence;

G) means responsive to a control signal for selecting between the received data byte and the error check code terms stored in the last of the second storage elements as a system output signal, wherein the control signal has a first or a second logic state associated therewith and wherein the received data byte is the system output signal when the control signal is a second logic state and the error check code terms stored in the last of the second storage elements is the system output signal when the control signal is the first logic state;

H) means responsive to the control signal for generating the storage control signal having a first logic state when the control signal is the first logic state;

I) means responsive to the storage control signal having the first logic state for transferring the groups of error check code terms, corresponding to the data sequence to a successive one of the second storage elements without modification and for providing the error check code terms in the last of the second storage elements as the system output signal; and

J) means for iteratively utilizing Element I to transfer out the plurality of groups of error check code terms comprising the error check code signal.

6. The system of Claim 5, wherein the means for selecting between the received data byte and the error check code terms in the last of the second storage elements is a multiplexor.

7. The system of Claim 5, wherein the means for generating the storage control signal includes a plurality of logical AND-gate elements.

8. The system of Claim 7, wherein certain of the distribution signals are received by a corresponding one of the plurality of logical AND-gate elements and the control signal is received by the plurality of logic AND-gate elements and logically AND-ed together by the AND-gate elements such that when the control signal is a first logic state, the logical AND-gate elements generate the storage control signal having the first logic state.

9. The system of Claim 7, wherein:
the first means for modulo 2 multiplying the distribution matrix and the received data signal includes the means for generating the storage control signal, and
each bit of the received data byte is provided as one input to one of the plurality of logical AND-gate elements and the control signal is provided as a second input to the plurality of logical AND-gate elements which logically AND the control signal and each bit of the received data byte to generate the storage control signal such that the storage control signal is multiplied by the distribution matrix to generate the plurality of distribution signals.

10. The system of Claim 9, wherein:
the distribution signals are a first logic level when the control signal is a first logic level.

11. The system of Claim 7, wherein the control signal and certain ones of the distribution signals generated by Element B are input to one of the logical AND-gate elements, wherein the logical AND-gate elements generate the storage control signal having the first logic state when the control signal is the first logic state.

12. A method for generating an error check code signal ($S_L$) in parallel and for reading out the error check code signal generated, wherein the error check code signal includes a plurality of error check code terms and is generated according to a generator polynomial having a plurality of generator terms (n) a received data sequence ($I_{0(L)}$) comprised of a plurality of data bytes each having a predetermined number data bits (z), comprising the steps of:

A) sequentially receiving a data byte ($I_{m(z)}$) in parallel;

B) modulo 2 adding the received data byte in parallel with a last group of error check code terms corresponding to a sequence of previously received data bytes to generate a plurality of parallel state signals, wherein the last group of error check code terms is shifted out of a last one of a plurality of sequentially arranged second storage elements;

C) modulo 2 multiplying the plurality of state signals in parallel with a distribution matrix ($B_z$) to generate a plurality of distribution signals each having a logic state associated therewith;

D) simultaneously shifting out of each of a plurality of sequentially arranged storage elements a group of the error check terms corresponding to the previously received sequence of data bytes, wherein the groups of error check code terms shifted out comprise an error check code ($S_m$) corresponding to the previously received data bytes ($I_{m(z)}$);

E) modulo 2 multiplying in parallel the error check code terms, shifted out in Step D with a state transition matrix ($A^z$) to generate a plurality of state signals;

F) modulo 2 adding the plurality of state signals and certain of the groups of distribution signals to generate in parallel certain of the error check code terms comprising the error check code signal ($S_{m+z}$) associated with the data bytes received;

G) simultaneously storing groups of the error check code terms in Step F in respective ones of the storage elements;

H) selecting, in response to a control signal, between the received data byte and the group of error check code terms stored out of the last of the storage elements as a system output signal;

I) modifying the logic states of the distribution signals in response to the control signal having a first logic state;

J) transferring the groups of error check code terms stored in the storage elements without modification to a successive one of the storage elements when the control signal is a first logic state; and

K) performing Step J to transfer out the plurality of groups of error check code terms comprising the error check code signal ($S_L$) associated with the data sequence ($I_{0(L)}$),

wherein the error check code signal corresponding to the data bytes received ($I_{0(L)}$) is generated according to the equation:

$$S_{m+z} = A^z * S_m + B_z * I_{m(z)}$$

where the distribution matrix has z distribution columns associated therewith and the state transition matrix has n transition columns associated therewith and the Z columns of the distribution matrix are identical to the highest Z columns in the state transition matrix, and for each iteration $S_m$ replaces $S_{m+z}$.

**13.** The method of Claim 12, wherein the first logic state is a logic zero.

**14.** The method of Claim 12, wherein the step of modifying the logic state of the distribution signals includes the step of:

L) logically AND-ing the control signal having the first logic state with the parallel state signals to generate a plurality of storage control signals,

such that the in Step C the storage control signals are modulo 2 multiplied with the distribution matrix to generate the distribution signals.

**15.** The method of Claim 12, wherein the step of modifying the logic state of the distribution signals, includes the step of:

M) logically AND-ing the distribution signals generated in Step C with the control signal to generate a storage control signal such that in Step F, the state signals are modulo 2 added to the storage control signal to generate certain of the error check code terms.

```
        3 3 2 2 2 2 2 2 2 2 2 1 1 1 1 1 1 1 1 1 1
        1 0 9 8 7 6 5 4 3 2 1 0 9 8 7 6 5 4 3 2 1 0 9 8 7 6 5 4 3 2 1 0    0

 31    0 1 0 0 0 0 0 0 0 0 0 0 0 0 0 0 0 0 0 0 0 0 0 0 0 0 0 0 0 0 0 0    0
 30    0 0 1 0 0 0 0 0 0 0 0 0 0 0 0 0 0 0 0 0 0 0 0 0 0 0 0 0 0 0 0 0    0
 29    0 0 0 1 0 0 0 0 0 0 0 0 0 0 0 0 0 0 0 0 0 0 0 0 0 0 0 0 0 0 0 0    0
 28    0 0 0 0 1 0 0 0 0 0 0 0 0 0 0 0 0 0 0 0 0 0 0 0 0 0 0 0 0 0 0 0    0
 27    0 0 0 0 0 1 0 0 0 0 0 0 0 0 0 0 0 0 0 0 0 0 0 0 0 0 0 0 0 0 0 0    0
 26    1 0 0 0 0 0 1 0 0 0 0 0 0 0 0 0 0 0 0 0 0 0 0 0 0 0 0 0 0 0 0 0    1
 25    0 0 0 0 0 0 0 1 0 0 0 0 0 0 0 0 0 0 0 0 0 0 0 0 0 0 0 0 0 0 0 0    0
 24    0 0 0 0 0 0 0 0 1 0 0 0 0 0 0 0 0 0 0 0 0 0 0 0 0 0 0 0 0 0 0 0    0
 23    1 0 0 0 0 0 0 0 0 1 0 0 0 0 0 0 0 0 0 0 0 0 0 0 0 0 0 0 0 0 0 0    1
 22    1 0 0 0 0 0 0 0 0 0 1 0 0 0 0 0 0 0 0 0 0 0 0 0 0 0 0 0 0 0 0 0    1
 21    0 0 0 0 0 0 0 0 0 0 0 1 0 0 0 0 0 0 0 0 0 0 0 0 0 0 0 0 0 0 0 0    0
 20    0 0 0 0 0 0 0 0 0 0 0 0 1 0 0 0 0 0 0 0 0 0 0 0 0 0 0 0 0 0 0 0    0
 19    0 0 0 0 0 0 0 0 0 0 0 0 0 1 0 0 0 0 0 0 0 0 0 0 0 0 0 0 0 0 0 0    0
 18    0 0 0 0 0 0 0 0 0 0 0 0 0 0 1 0 0 0 0 0 0 0 0 0 0 0 0 0 0 0 0 0    0
 17    0 0 0 0 0 0 0 0 0 0 0 0 0 0 0 1 0 0 0 0 0 0 0 0 0 0 0 0 0 0 0 0    0
 16    1 0 0 0 0 0 0 0 0 0 0 0 0 0 0 0 1 0 0 0 0 0 0 0 0 0 0 0 0 0 0 0    1
 15    0 0 0 0 0 0 0 0 0 0 0 0 0 0 0 0 0 1 0 0 0 0 0 0 0 0 0 0 0 0 0 0    0
 14    0 0 0 0 0 0 0 0 0 0 0 0 0 0 0 0 0 0 1 0 0 0 0 0 0 0 0 0 0 0 0 0    0
 13    0 0 0 0 0 0 0 0 0 0 0 0 0 0 0 0 0 0 0 1 0 0 0 0 0 0 0 0 0 0 0 0    0
 12    1 0 0 0 0 0 0 0 0 0 0 0 0 0 0 0 0 0 0 0 1 0 0 0 0 0 0 0 0 0 0 0    1
 11    1 0 0 0 0 0 0 0 0 0 0 0 0 0 0 0 0 0 0 0 0 1 0 0 0 0 0 0 0 0 0 0    1
 10    1 0 0 0 0 0 0 0 0 0 0 0 0 0 0 0 0 0 0 0 0 0 1 0 0 0 0 0 0 0 0 0    1
  9    0 0 0 0 0 0 0 0 0 0 0 0 0 0 0 0 0 0 0 0 0 0 0 1 0 0 0 0 0 0 0 0    0
  8    1 0 0 0 0 0 0 0 0 0 0 0 0 0 0 0 0 0 0 0 0 0 0 0 1 0 0 0 0 0 0 0    1
  7    1 0 0 0 0 0 0 0 0 0 0 0 0 0 0 0 0 0 0 0 0 0 0 0 0 1 0 0 0 0 0 0    1
  6    0 0 0 0 0 0 0 0 0 0 0 0 0 0 0 0 0 0 0 0 0 0 0 0 0 0 1 0 0 0 0 0    0
  5    1 0 0 0 0 0 0 0 0 0 0 0 0 0 0 0 0 0 0 0 0 0 0 0 0 0 0 1 0 0 0 0    1
  4    1 0 0 0 0 0 0 0 0 0 0 0 0 0 0 0 0 0 0 0 0 0 0 0 0 0 0 0 1 0 0 0    1
  3    0 0 0 0 0 0 0 0 0 0 0 0 0 0 0 0 0 0 0 0 0 0 0 0 0 0 0 0 0 1 0 0    0
  2    1 0 0 0 0 0 0 0 0 0 0 0 0 0 0 0 0 0 0 0 0 0 0 0 0 0 0 0 0 0 1 0    1
  1    1 0 0 0 0 0 0 0 0 0 0 0 0 0 0 0 0 0 0 0 0 0 0 0 0 0 0 0 0 0 0 1    1
  0    1 0 0 0 0 0 0 0 0 0 0 0 0 0 0 0 0 0 0 0 0 0 0 0 0 0 0 0 0 0 0 0    1
                                    A⁰                                    B₀
       └──────────────────────────────────────────────────┘           └──┘
                              201a                                      101a
```

FIG. 1

```
        3 3 2 2 2 2 2 2 2 2 2 2 1 1 1 1 1 1 1 1 1 1
        1 0 9 8 7 6 5 4 3 2 1 0 9 8 7 6 5 4 3 2 1 0 9 8 7 6 5 4 3 2 1 0   7 6 5 4 3 2 1 0

31   0 0 1 0 0 0 0 1 0 0 0 0 0 0 0 0 0 0 0 0 0 0 0 0 0 0 0 0 0 0 0 0   0 0 1 0 0 0 0 0
30   1 0 0 1 0 0 0 0 1 0 0 0 0 0 0 0 0 0 0 0 0 0 0 0 0 0 0 0 0 0 0 0   1 0 0 1 0 0 0 0
29   1 1 0 0 1 0 0 0 0 1 0 0 0 0 0 0 0 0 0 0 0 0 0 0 0 0 0 0 0 0 0 0   1 1 0 0 1 0 0 0
28   0 1 1 0 0 1 0 0 0 0 1 0 0 0 0 0 0 0 0 0 0 0 0 0 0 0 0 0 0 0 0 0   0 1 1 0 0 1 0 0
27   1 0 1 1 0 0 1 0 0 0 0 1 0 0 0 0 0 0 0 0 0 0 0 0 0 0 0 0 0 0 0 0   1 0 1 1 0 0 1 0
26   0 1 0 1 1 0 0 1 0 0 0 0 1 0 0 0 0 0 0 0 0 0 0 0 0 0 0 0 0 0 0 0   0 1 0 1 1 0 0 1
25   0 0 0 0 1 1 0 0 0 0 0 0 0 1 0 0 0 0 0 0 0 0 0 0 0 0 0 0 0 0 0 0   0 0 0 0 1 1 0 0
24   1 0 0 0 0 1 1 0 0 0 0 0 0 0 1 0 0 0 0 0 0 0 0 0 0 0 0 0 0 0 0 0   1 0 0 0 0 1 1 0
23   0 1 0 0 0 0 1 1 0 0 0 0 0 0 0 1 0 0 0 0 0 0 0 0 0 0 0 0 0 0 0 0   0 1 0 0 0 0 1 1
22   0 0 0 0 0 0 1 0 0 0 0 0 0 0 0 0 1 0 0 0 0 0 0 0 0 0 0 0 0 0 0 0   0 0 0 0 0 0 0 1
21   0 0 1 0 0 0 0 0 0 0 0 0 0 0 0 0 0 1 0 0 0 0 0 0 0 0 0 0 0 0 0 0   0 0 1 0 0 0 0 0
20   0 0 0 1 0 0 0 0 0 0 0 0 0 0 0 0 0 0 1 0 0 0 0 0 0 0 0 0 0 0 0 0   0 0 0 1 0 0 0 0
19   1 0 0 0 1 0 0 0 0 0 0 0 0 0 0 0 0 0 0 1 0 0 0 0 0 0 0 0 0 0 0 0   1 0 0 0 1 0 0 0
18   1 1 0 0 0 1 0 0 0 0 0 0 0 0 0 0 0 0 0 0 1 0 0 0 0 0 0 0 0 0 0 0   1 1 0 0 0 1 0 0
17   0 1 1 0 0 0 1 0 0 0 0 0 0 0 0 0 0 0 0 0 0 1 0 0 0 0 0 0 0 0 0 0   0 1 1 0 0 0 1 0
16   0 0 1 1 0 0 0 1 0 0 0 0 0 0 0 0 0 0 0 0 0 0 1 0 0 0 0 0 0 0 0 0   0 0 1 1 0 0 0 1
15   1 0 1 1 1 0 0 0 0 0 0 0 0 0 0 0 0 0 0 0 0 0 0 1 0 0 0 0 0 0 0 0   1 0 1 1 1 0 0 0
14   1 1 0 1 1 1 0 0 0 0 0 0 0 0 0 0 0 0 0 0 0 0 0 0 1 0 0 0 0 0 0 0   1 1 0 1 1 1 0 0
13   1 1 1 0 1 1 1 0 0 0 0 0 0 0 0 0 0 0 0 0 0 0 0 0 0 1 0 0 0 0 0 0   1 1 1 0 1 1 1 0
12   0 1 1 1 0 1 1 1 0 0 0 0 0 0 0 0 0 0 0 0 0 0 0 0 0 0 1 0 0 0 0 0   0 1 1 1 0 1 1 1
11   0 0 0 1 1 0 1 1 0 0 0 0 0 0 0 0 0 0 0 0 0 0 0 0 0 0 0 1 0 0 0 0   0 0 0 1 1 0 1 1
10   0 0 1 0 1 1 0 1 0 0 0 0 0 0 0 0 0 0 0 0 0 0 0 0 0 0 0 0 1 0 0 0   0 0 1 0 1 1 0 1
 9   0 0 1 1 0 1 1 0 0 0 0 0 0 0 0 0 0 0 0 0 0 0 0 0 0 0 0 0 0 1 0 0   0 0 1 1 0 1 1 0
 8   0 0 0 1 1 0 1 1 0 0 0 0 0 0 0 0 0 0 0 0 0 0 0 0 0 0 0 0 0 0 0 1   0 0 0 1 1 0 1 1
 7   1 0 1 0 1 1 0 1 0 0 0 0 0 0 0 0 0 0 0 0 0 0 0 0 0 0 0 0 0 0 0 0   1 0 1 0 1 1 0 1
 6   1 1 1 1 0 1 1 0 0 0 0 0 0 0 0 0 0 0 0 0 0 0 0 0 0 0 0 0 0 0 0 0   1 1 1 1 0 1 1 0
 5   1 1 1 1 1 0 1 1 0 0 0 0 0 0 0 0 0 0 0 0 0 0 0 0 0 0 0 0 0 0 0 0   1 1 1 1 1 0 1 1
 4   0 1 0 1 1 1 0 1 0 0 0 0 0 0 0 0 0 0 0 0 0 0 0 0 0 0 0 0 0 0 0 0   0 1 0 1 1 1 0 1
 3   1 0 0 0 1 1 1 0 0 0 0 0 0 0 0 0 0 0 0 0 0 0 0 0 0 0 0 0 0 0 0 0   1 0 0 0 1 1 1 0
 2   1 1 0 0 0 1 1 1 0 0 0 0 0 0 0 0 0 0 0 0 0 0 0 0 0 0 0 0 0 0 0 0   1 1 0 0 0 1 1 1
 1   1 1 0 0 0 0 1 1 0 0 0 0 0 0 0 0 0 0 0 0 0 0 0 0 0 0 0 0 0 0 0 0   1 1 0 0 0 0 1 1
 0   0 1 0 0 0 0 0 1 0 0 0 0 0 0 0 0 0 0 0 0 0 0 0 0 0 0 0 0 0 0 0 0   0 1 0 0 0 0 0 1

                                   A⁸                                        B₈
```

$A^8$ $\qquad$ $B_8$

201 $\qquad$ 101

# FIG.2

FIG. 3

FIG. 4

EP 0 431 416 A2

FIG. 5

EP 0 431 416 A2